# EUROPEAN PATENT SPECIFICATION

(11) **EP 0 653 826 B1**
(45) Date of publication and mention of the grant of the patent: **03.02.1999**
(21) Application number: 94118157.0
(22) Date of filing: 17.11.1994
(51) Int. Cl.: H02J 7/00, G06F 1/30

(54) **Battery-driven electronic appliance**
Batteriebetriebenes elektronisches Gerät
Appareil électronique alimenté par une batterie

(30) Priority: 17.11.1993 JP 287885/93; 18.11.1993 JP 288944/93; 18.11.1993 JP 288943/93; 18.11.1993 JP 288946/93
(43) Date of publication of application: 17.05.1995
(73) Proprietor: NEC CORPORATION, Tokyo (JP)
(72) Inventor: Endo, Kaoru, c/o NEC Corporation, Minato-ku, Tokyo (JP)
(74) Representative: VOSSIUS & PARTNER

(56) References cited:
- EP-A- 0 355 461
- EP-A- 0 518 039
- WO-A-90/02670
- DE-A- 4 101 614
- FR-A- 2 561 391
- FR-A- 2 635 938
- PATENT ABSTRACTS OF JAPAN vol. 15, no. 477 (P-1283) 4 December 1991 & JP-A-03 204 712 (SHARP) 6 September 1991
- PATENT ABSTRACTS OF JAPAN vol. 13, no. 452 (P-943) 12 October 1989 & JP-A-01 175 015 (TOSHIBA) 11 July 1989
- PATENT ABSTRACTS OF JAPAN vol. 18, no. 214 (P-1727) 15 April 1994 & JP-A-06 012 376 (TOSHIBA) 21 January 1994

## Description

The present invention relates to an electronic appliance driven by a primary or secondary battery and, in particular, to a battery-driven electronic appliance having a function of automatically switching the operating modes according to the degree to which the battery is consumed. Furthermore, the present invention relates to a battery-driven electronic appliance having a function of issuing an alarm by determining the advent of the time at which the battery should be replaced or electrically recharged.

In a hand-held electronic appliance such as notebook-type personal computers, word processors, electronic notebooks, or in an electronic appliance for indoor or outdoor use, such as hand-held compact disk players, television sets having a liquid crystal display, camera-integrated video tape recorders, stress is laid to the readiness to use it or its basic performance when the battery is driven as the electric supply rather than when it is connected to the commercial AC power supply.

In particular, such electronic appliances are typically arranged so that the primary battery such as the disposable alkali battery or the like can also be used as the power supply not to say of the secondary battery such as the rechargeable nickel-cadmium battery or nickel-hydrogen battery. Since the primary battery cannot be recharged, it is necessary to replace it by a new primary one when the output voltage is reduced to below the minimum voltage at which the electronic appliance is warranted to operate, and to this end, many of handheld electronic appliances incorporate a battery voltage monitor which alarms the advent of the time the battery should be replaced.

Furthermore, in the battery-driven electronic appliance developed on the assumption that the secondary battery is used, in order to assure the continuous usage time, some device is used to block a so-called memory effect, which is peculiar to the secondary battery, from generating. As well known, if recharging of the second battery is carried out with its end voltage not consumed, the memory effect is caused and the voltage at which the recharging is conducted is stored, which when discharging is conducted next, the battery cannot be discharged down to the memory voltage with the result that, as often pointed out, the electric power from the memory voltage down to the end voltage cannot be used.

In order to solve such a drawback, it is also conceivable as one measure to enlighten users with instruction manuals so that they do not impair the battery lifetime substantially due to the memory effect to refrain from frequently recharging it at the early stage in which the discharging is insufficient, but it is not well enough alone. Therefore, a method has been recommended in which before the secondary battery which has not been discharged completely is charged a discharger, for example, is used to discharge down to the end voltage once for subsequent recharging.

However, with such a conventional measure against the memory effect, in which the battery is charged after being compulsorily discharged by means of the discharger, it becomes necessary to purchase as an option a special discharger attached with an overdischarge preventing function which damages the secondary battery, other than the electronic appliance, the main body, in order to compulsorily discharge the second battery, which necessarily leads to the inevitable increase of burden which users must take.

In order to alleviate the user's burden of purchasing the optional part, as disclosed in, for example, Japanese Patent Laid-Open 4-190638, a battery-driven electronic appliance incorporating the discharging function and the over-discharging preventing function, which are required of the discharger, within the appliance per se, has been developed. In this type of appliance, when the output voltage (nominal voltage 6.0 V) of the secondary battery which is incorporated within the camera-integrated video tape recorder is reduced to the cut-off voltage (for example, 5.8 V) at which the main load within the electronic appliance cannot be compensated for in operation, the interval between the load and the secondary battery is interrupted once. Furthermore, when it is definitely found that user has no will to use the appliance (for example, when it was confirmed that the tape cassette is not fitted to the video tape recorder), the threshold voltage is automatically switched from the cut-off voltage further down to the low end voltage (for example, 5.0 V) so as to discharge the second battery to a voltage lower than the cut-off voltage, and it is discharged by making the secondary battery electrically conductive to the load with the video and acoustic outputs inhibited. Therefore, the appliance can ccmpletely discharge the battery to eliminate the memory effect by itself by only leaving the video tape recorder as it is with the tape cassette removed and with the power supply turned on, and the user can be released from the need to use the discharger.

On the other hand, the battery alarm is effective as a means for informing the user of the battery replacing time or charging time and driving the resume function as necessary. For example, there is a power saving type arrangement available to many battery-driven electronic appliances such as the notebook type personal computer or word processor, in which, in order to extend the substantial usage time until the battery alarm is issued, CPU is shifted to HALT state while the key is entered to select the power saving mode.

However, during such power saving mode, since the CPU is put in the HALT condition in which its processing operation is interrupted, in a so-called personal word processor as described in , for example, JPA Hei 1-175015, in order not to miss keying, it is checked by regularly operating the halting CPU by interruption of the timer in a predetermined cycle, and when it is found that keying was made, a key code corresponding to it is previously stored once into a key buffer area within RAM to carry out the process corresponding to the key code stored within the key buffer area within a main routine which has resumed after the interruption process so that the keying never fails to be checked even under the halt condition. As one aiming at saving the electric power in the same manner, there is a circuit for reducing the power consumption disclosed in JPA Sho 59-79325. The above conventional circuit uses, for example, 16 milliseconds, which is the maximum time not incurring the missing of the keying management, as the timer interruption cycle during the power saving mode, and when CPU spends 1 milliseconds as the operating time required to scan the key, allows the electric power to be saved by about 1 : 16 as simply calculated in terms of time ratio before.

Another known apparatus is disclosed in JPA Hei 4-71335, in which, when the output voltage of the secondary battery is lowered to a voltage between two threshold voltages, the electric power is supplied to the load only which is required for maintenance while supply of the electric power to the load great in power consumption is interrupted, and when the output voltage becomes lower than the lower threshold voltage, the secondary battery is released from the load.

In the foregoing conventional battery-driven electronic appliance, the battery voltage monitor operates to monitor the advent of the battery replacing time or charging time based on the threshold voltages. However, in the battery-driven electronic appliance, since various loads which each differ in current consumption are made electrically conductive as necessary according to the operating object, the output voltage will be lowered by the amount which is obtained by multiplying the load current by the internal resistance within the battery. As a result, if the light load still retains a capability of maintaining the minimum operating warranted voltage while a heavy load great in current consumption is driven, then, since the voltage drop due to the internal resistance of the battery is great, it often happens that the battery voltage monitor alarms the advent of the time the battery should be replaced. In this case, although the extra power electrically conducted to the load still remains, user cannot help replacing or recharging the battery at too early stages leading to the waste of the battery resource or electric power resource.

Furthermore, when the cut-off voltage is taken as the threshold value, in an arrangement in which the current consumption is arbitrarily made electrically conductive for various different loads according to the operating purpose, each time the appliance is made electrically conductive, the output voltage of the secondary battery will drop by the load current multiplied by the internal resistance of the battery involving the fluctuation. Therefore, it is not proper to monitor the output voltage of the secondary battery according to not the operating condition of the load, but the same shut-off voltage. For example, the current cannot be cut off by monitoring the acoustic sound while when a load relatively great in current consumption such as the zooming mechanism is driven the monitor which has captured the reduction of current down to the cut-off voltage will compulsorily cut off the secondary battery from the load though the extra conductive power is left.

In particular, in the electronic appliance such as the camera-incorporated video tape recorder or the like, since a three-terminal regulator is interleaved between the secondary battery and the load, the minimum input voltage of the three-terminal regulator will be selected as the operation-warranted voltage and, in this case, the cut-off voltage. In consequence, the cut-off voltage (5.8 V) is very close to the nominal voltage (6.0 V) of the secondary battery and, for example, if the output of the secondary battery has been reduced to below the cut-off voltage during the image pickup by camera, since the interval between the secondary battery and the load is completely cut off, even the tape cassette cannot often be withdrawn as long as the battery is not replaced, while it leaves at most the capability of driving the eject mechanism.

An object of the present invention is to provide a battery-driven electronic appliance which allows the battery replacing or recharging time to be precisely determined without mistake.

This object is achieved by the features of claim 1.

The battery-driven electronic appliance according to the present invention comprises an interface circuit which converts the battery alarm signal emitted by the battery voltage monitor into the alarm code, which is the pseudo key code, to feed into CPU as the key input.

The battery-driven electronic appliance according to the present invention further comprises
a group of loads driven upon receipt of the electric current from the battery;
means for generating two different threshold voltages;
   and
voltage switching means for selecting the lower output voltage of the threshol voltage generating means while one or more specific loads which are selected from among the group of loads are operating and for selecting the higher output voltage of the threshold voltage generating means while they are not operating, wherein
said battery voltage monitoring portion is connected to an electrically conductive line connecting the group of loads and the battery for determining whether the output voltage of the battery is greater or smaller than either one of the two threshold voltages taken as the reference to generate said alarm signal.

According to the foregoing arrangement, if any specific load(s) is (are) operating on the battery voltage monitoring portion, the voltage monitoring operation is substantially stopped so that the premature mistaken determination of the replacing or recharging time can be prevented. In particular, in the case of the secondary battery, it cannot happen that the recharging time is determined by mistake according to the output voltage of the secondary battery which has temporarily been reduced by the load current so that the premature recharging is conducted causing the memory effect.

According to a preferred embodiment of the present invention, after a predetermined period of time, i.e., the settling time, elapses after the operation of the load is stopped, the threshold voltage value is switched to the lower preset value. Within this settling time, the battery is returned to a normal discharging condition, and the mistaken determination of the cell replacing or recharging time can be prevented.

The battery-driven electronic appliance according to the present invention may further comprise a means for substantially monitoring the voltage monitoring operation when any specific load(s) of the group of loads of the battery is (are) operating on the voltage monitor. An interruption serves as mistaken determination such as taking the output voltage of the secondary battery which has temporarily been lowered due to the load current at its face value, or prematurely recharging by mistaken determination of the recharging time to incur the memory effect.

The battery-driven appliance according to the present invention may comprise two kinds of high and low threshold voltage sources to which the threshold value voltage generator is selectively connected to the terminal of the battery voltage monitor to which the threshold value voltage is applied via the switch and a control means for switching the switch in response to the operating instruction. Therefore, the monitoring system can be achieved only by connecting the two kinds of threshold voltage sources to the battery voltage monitor via the switch to make the voltage of each threshold voltage source correspond to the high and low threshold values respectively. In addition, since, in order to monitor the battery voltage, it is sufficient to switch the switch according to the operating state of the specific load(s), mistake in setting the threshold voltage is small, and a correct monitoring of the battery voltage can be achieved.

In addition, if the specific load is arranged with a floppy disk unit which drives the floppy disk for rotation by means of a motor driven by the secondary battery to read and write data from and to the floppy disk via a magnetic head, the output voltage of the secondary battery is reduced by the voltage obtained by multiplying the current consumption by the internal resistance of the battery due to the current consumed by the motor as the floppy disk is rotated. However, according to the present invention, since the voltage drop involved with such a load current can be previously confirmed by calculation or by experiment, the two (high and low) kinds of threshold voltages which are set to the battery voltage monitor can be precisely set and the management of the proper recharging time taking the operating condition of the load into account can be achieved.

### BRIEF DESCRIPTION OF THE DRAWINGS

Figure 1 is a perspective view illustrating the external appearance of a specific embodiment of a battery-driven electronic appliance according to the present invention;
Figure 2 is a block diagram illustrating an electric circuit of the battery-driven electronic appliance of Figure 1;
Figure 3 is a circuit diagram of a battery voltage monitoring portion of the electric circuit illustrated in Figure 2;
Figure 4 is a flowchart illustrating a main routine executed by a CPU of the electric circuit illustrated in Figure 2; and
Figure 5 is a flowchart illustrating a timer interrupt routine executed by the CPU of the electric circuit illustrated in Figure 2.

### DETAILED DESCRIPTION OF THE PREFERRED EMBODIMENTS

A specific embodiment of the present invention is hereinafter described with reference to the accompanying drawings.

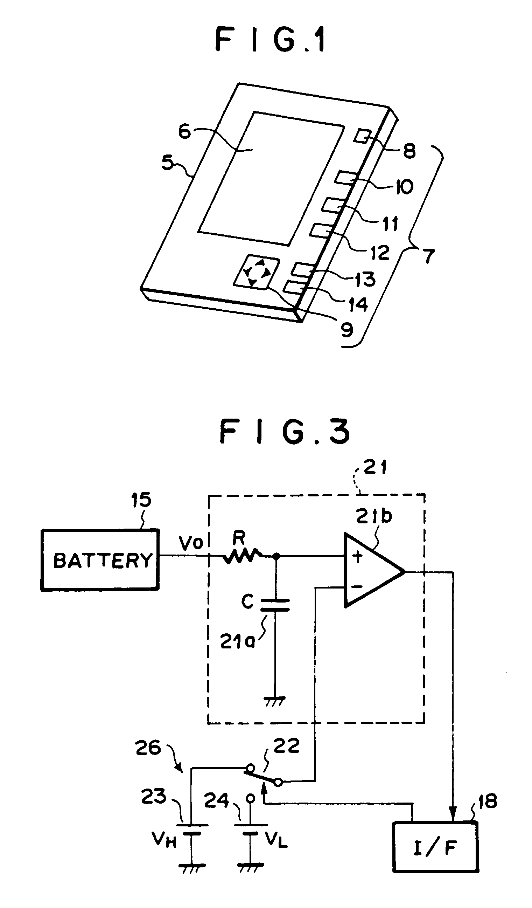

Figure 1 is an external view of a specific embodiment of a battery-driven electronic appliance according to the present invention. The battery-driven electronic appliance 1 of this embodiment is a hand-held electronic appliance called a "digital book", or "electronic book", and is arranged so that the information recorded on a data storage medium can be read through by reading out on the screen, and is expected as a next generation merchandise carrying the publishing culture in place of paper.

A battery-driven electronic appliance 1 comprises a liquid crystal display 6 disposed on the front surface of a casing 5 of thin notebook size and a keyboard unit 7 disposed along one lateral edge of the casing 5. The keyboard unit 7 comprises a power supply key 8, a cursor key 9 for shifting laterally and vertically on the screen of a liquid crystal display 6, a function key 10 for reading the menu, an index key 11 for reading out the page of the index, a cancel key 12 for interrupting the operation and a plurality of input keys including a preceding page key 13 and a next page key 14 for turning page.

A specific arrangement of the battery-driven electronic appliance 1 illustrated in Figure 1 is for the illustration purpose only, and the present invention can be applied to many other battery-driven electronic appliances.

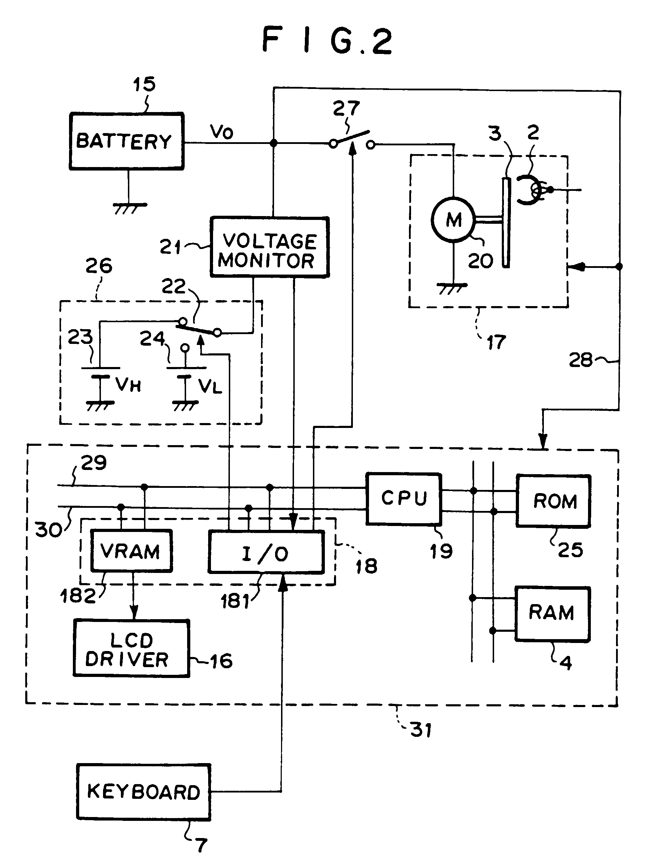

As shown in Figure 2, the battery-driven electronic appliance is provided with a floppy disk unit 17. Data can be arbitrarily read from and written to the floppy disk unit 17 by means of a magnetic head 2, and is provided with a floppy disk 9 driven for rotation by means of a motor 20. A memory map of the floppy disk 3 is sectioned into three types of areas: an area for storing book data in which the content of the publication such as novel or comics is stoped, an area for storing an application program in which an application program necessary for display is stored, an area for storing resume data in which resume data is temporarily stored.

Furthermore, an electronic circuit 31 performing a predetermined operation according to the instruction from the keyboard unit 7 is intended for taking out the information from, for example, the floppy disk unit 17 and, for, after it carries out a necessary processing, achieving various functions including the function of displaying the information on the liquid crystal display 6, and is provided with an interface circuit 18, a CPU 19, a ROM 25, a RAM 4 and an LCD driving circuit 16.

Connected to the CPU 19 are a ROM 26 for storing a driving program or a BIOS and a RAM 4 for writing book data or the like which is necessary for display via a data bus and an address bus respectively. The memory map of the RAM 4 is sectioned into several areas: an area for storing an application program in which the application program read out from the floppy disk 3 is stored, an area for storing book data in which the book data read out from the floppy disk 3 block by block is stored, a RAM area for storing graphic data or text data displayed on the screen, and a key buffer area for storing the key inputs amounting to, at most, 16 each as the key code. Data stored within the book data storage area of the floppy disk 3 is written sectioned into a plurality of blocks with, for example, 32 Kilobyte data taken as one block, and also when it is read out to the RAM 4 within the battery-driven electronic appliance 1, it is read out by a specified block, that is, by 32 Kilobyte data only.

CPU 19 is also connected to the interface circuit 18 via the data bus 29 and the address bus 30. The interface circuit 18 is provided with an I/O port 181 and a VRAM 182, and a LCD driver 16 is connected to the VRAM 182 to drive the liquid crystal display 6. Furthermore, to the I/O port 181, the output of the battery-driven monitoring circuit 21 and the keyboard unit 7 is supplied and switches 22, 27 are controlled according to the signal from the CPU.

Since the arrangement and operation of the foregoing electronic circuit 31 per se are generally known in this field, their detailed description is omitted.

A battery 15 for providing the operating current to the floppy disk unit 17 and the electronic circuit 31 may be a primary battery such as the disposable alkali battery or the like, or the rechargeable secondary battery such as the nickel/cadmium battery or nickel/hydrogen battery. For example, the battery 15 may be four tan-san alkali dry batteries of nominal voltage 1.5 V, or may be the battery pack (nominal voltage 6.4 V) having an assembly of four nickel/cadmium (Ni-Cd) batteries of nominal voltage 1.6 V. In this text, the term "battery" is used as including both of this battery assembly and the battery pack, and this battery is releasably set at predetermined positions of the battery-driven electronic appliance. In the battery-driven electronic appliance according to the present invention, the replacing time (if the primary battery is used) and the recharging time (if the secondary battery is used) are notified.

The output terminal of the battery 15 is connected to the floppy disk unit 17, which is the first load, and the electronic circuit 31, which is the second load, via a power line 28. Since the floppy disk unit 17 is arranged to read and write data to and from the track by rotating the fitted floppy disk 3, within the battery-driven electronic appliance, the motor 20 of the floppy disk unit 17 is the greatest power consuming source.

The battery 15 discharges electricity as it is used. In order to prevent the wear of this battery from giving a serious disturbance to the operation of the appliance, a battery voltage monitor 21 is connected to its output terminal. This battery voltage monitor 21 monitors the advent of the replacing or recharging time based on a predetermined threshold voltage and, when it is determined that they have arrived, executes a following operation.

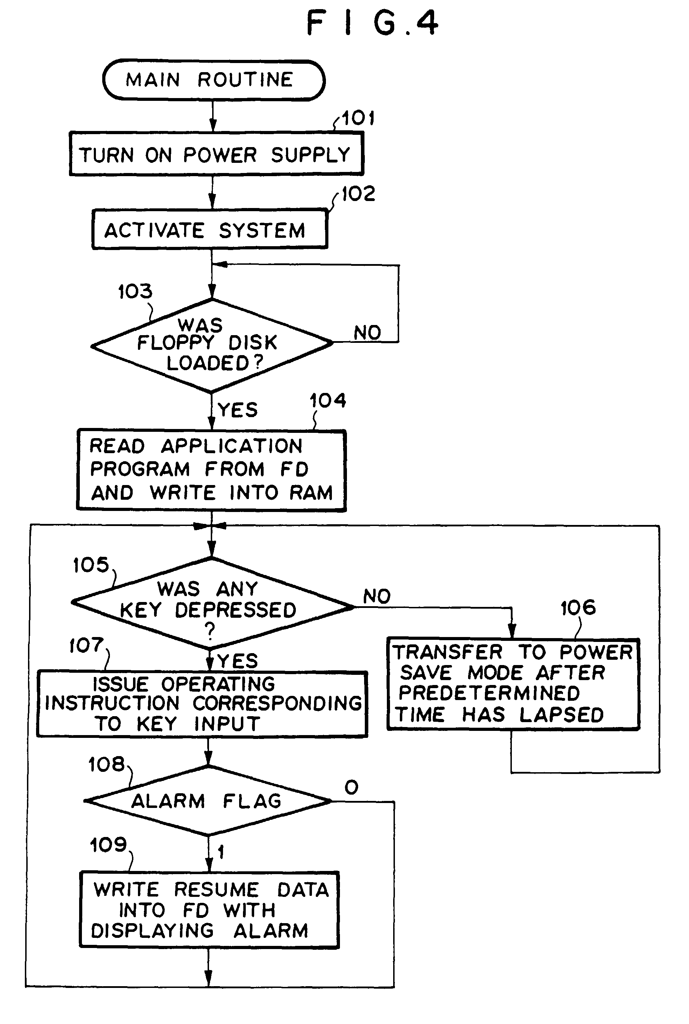

The voltage monitor 21, as shown in Figure 3, comprises a battery voltage holding circuit 21a in which a capacitor C is connected to the output terminal of the battery 15 via a recharging resistance R and a comparator 21b in which the terminal voltage of the capacitor C is applied to the comparing input terminal and the two kinds (high and low) of threshold voltages V_{H}, V_{L} are selectively applied to the reference input terminal (terminal applied with the threshold voltage) via the switch 22. Signs 23, 24 each denote a voltage source for the threshold voltage V and, in the case of the primary battery having a nominal voltage of 6.0 V, the high voltage threshold V_{H} is set to, for example, 4.1 V, and the low voltage threshold V_{L} is set to, for example, 3.9 V. In the case of the secondary battery having a nominal voltage of 6.4 V, the high voltage threshold V_{H} is set to, for example, 4.4 V, and the low voltage threshold V_{L} is set to, for example, 3.9 V.

As peculiar to the battery-driven electronic appliance 1, the voltage monitor 21 monitors the output voltage V₀ of the battery 15 constantly and continuously, unless the key is depressed in excess of a predetermined period of time, CPU 19 shifts to HALT condition automatically, in which it selects the power saving mode in which it restricts itself to the necessary minimum operation to suppress the useless power consumption, and while it is in this power saving mode, the key code is transferred from the key input BIOS to the CPU which, only after that, can return to the normal operation mode.

Selection of the threshold voltage V_{H} or V_{L} is carried out by CPU 19 switching the switch 22 depending on whether the motor 20 of the floppy disk unit 17 is electrically conductive or not. If a switch 27 connected to the motor 20 of the floppy disk unit 17 is closed, the low threshold voltage V_{L} is selected in consideration of the reduction of the output voltage V₀ of the battery 15 involved with the increase of the current consumption. Furthermore, if the switch 27 is open, since the current consumption is also small and the output voltage V₀ of the battery 15 is not lowered so much, the high threshold voltage V_{H} is selected.

The battery-driven electronic appliance according to the present invention can be arranged so that when the recharging or replacing time comes it displays an alarm and resumes. In this case, as described later, CPU 19 takes in the output of the voltage monitor 21 in the process of the timer interrupt routine. At this stage, CPU 19 restricts its operation to setting an alarm flag, but when the alarm flag is discriminated within the following main routine, displays an alarm and resumes.

The alarm display and the resume action are described with reference to a flow chart of Figure 4.

First, when the battery-driven electronic appliance 1 is used, the power supply key 8 is depressed to turn on the power supply (step 101), and subsequently, in step 102, the system is driven according to a driving program within the ROM 26. Next, in step 103, it is determined that the floppy disk 3 is fitted in the floppy disk unit 17 and, then, in the subsequent step 104, the application program is read out from the floppy disk 3 to be written into the application program storage area within RAM 4. Thus, the condition in which the liquid crystal 6 is displayed is established.

Next, CPU 19 monitors whether the key is depressed or not and, when the key depression is interrupted for over a predetermined period of time, shifts to the power saving mode in step 106 following step 105 to switch the display luminance of the liquid crystal display 6 to the minimum level. On the other hand, if the key was depressed before shifting to the power saving mode, then, in step 107, it issues an operating instruction according to the key depression.

If the user depresses the index key 11, then the index page is displayed on the liquid crystal display 6, and a desired chapter can be specified by manipulating the cursor key 9. The book data corresponding to 32 Kilobytes which is related to the specified chapter, after read out from the floppy disk 3, is written into the book data storage area within RAM 4. Furthermore, the first page of the specified chapter is displayed on the liquid crystal display 6 and, thereafter, he or she can enjoy reading on the liquid crystal display 6 by manipulating the next page key 14 or the preceding page key 13.

Whether the key is entered or not is determined by checking whether there is any key code stored or not within the key buffer area of RAM 4 and, specifically, within the timer interrupt routine (described later). Among these key codes, there is such an alarm code resulting from converting the alarm flag indicating the advent of the recharging time into a harmless code causing no trouble to the operation included (for example, the pseudo key code converted into the hexadecimal representation, such as 7A or 7B according to ASCII code). Therefore, since the key is not depressed by way of the keyboard unit 7, it can be avoided by the use of the alarm code that although, actually, the alarm display was executed, the operation is stopped in step 106 and step 107, and cannot be passed through.

That is, if the key is depressed, or the alarm code is present, then the procedure is shifted through step 107 to step 108 according to the referencing result of the key buffer area. In step 108, it is determined whether the alarm flag is established (flag "1") or not (flag "0"), and if yes, then, in step 109, the alarm is displayed on the screen of the liquid crystal display 6 while the resume data is written into the resume data storage area of the floppy disk 3.

As the resume data, data regarding the document screen "chapter" and "page" are considered which had been displayed on the display 6 at the time the alarm generated.

On the other hand, the timer interrupt routine is executed for each predetermined interrupt cycle (for example, 1/16 sec), and the alarm processing (the flag is established upon generation of the alarm), key input process (the key code corresponding to the key input is written into the key buffer area), process for blinking the cursor, or process for informing the advent of the interrupt cycle or the like are each executed as the subroutine according to a predetermined sequence.

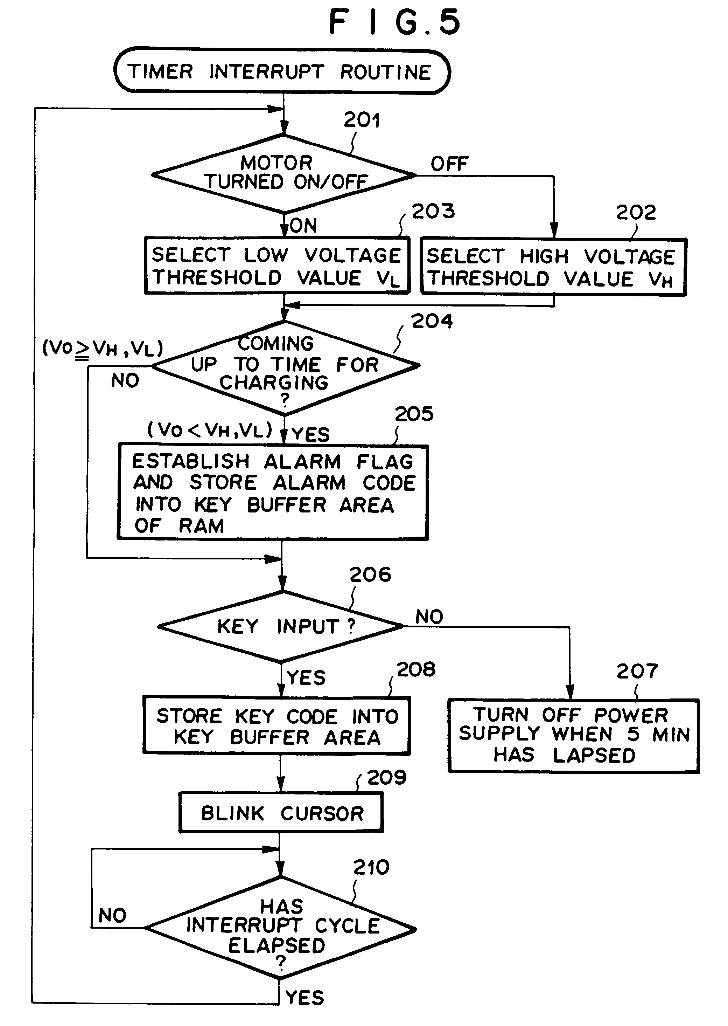

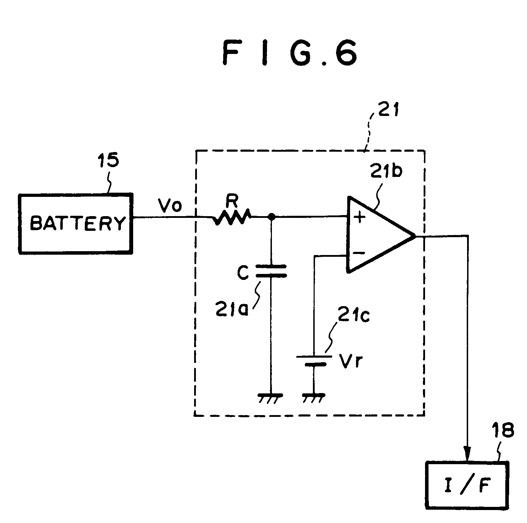

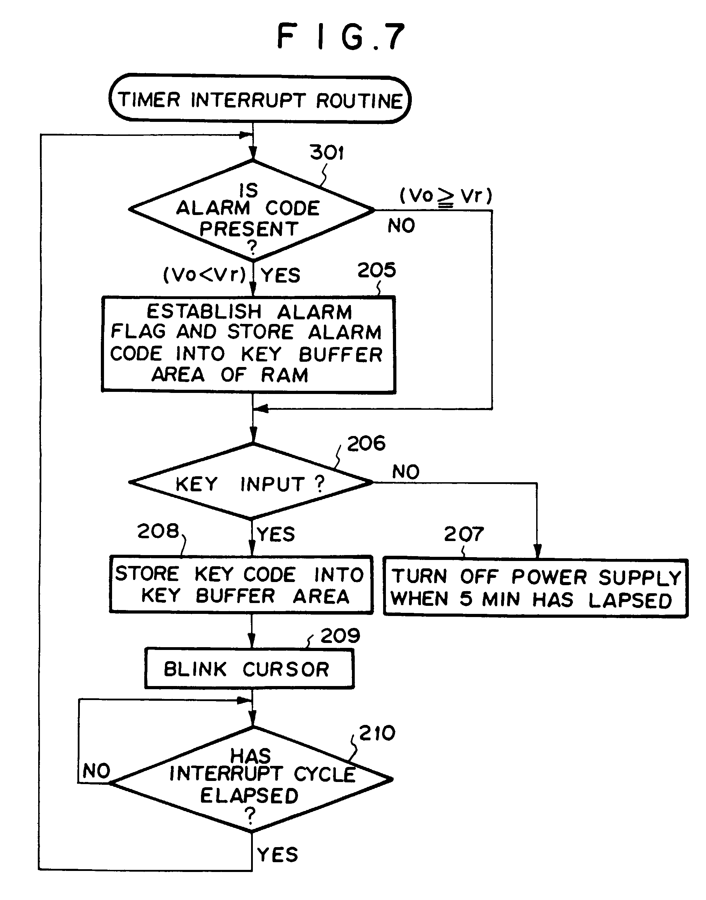

If, the timer interrupt routine of Figure 5 is executed by the timer interruption, then, first in step 201, it is determined whether the alarm code passing through the interface circuit 18 is present or not (it is determined whether the recharging or battery replacing time has come or not). That is, if the output voltage V₀ of the battery 15 applied to the comparing input terminal of the comparator 21b within the voltage monitor 21 becomes higher than the threshold voltage given to the reference input terminal, then the output of the comparator 21b is turned into LOW level, which is taken into CPU 19 as the battery alarm signal by way of the interface circuit 18.

Since the interface circuit 18 converts the battery alarm signal into the alarm code comprising the foregoing pseudo code, CPU 19 which has received it as the pseudo key code establishes an alarm code in step 202 while storing the latter into the key buffer area within RAM 4. However, at this stage, the alarm flag alone is established, and the actual alarm display is executed within the main routine, as described above.

On the other hand, if it is found out in step 201 that the alarm code passing through the interface circuit 18 is not present and that the recharging time has not come, then the step 202 is not passed through, and the procedure is immediately shifted to the key depression process subroutine in steps 203 through 205. Incidentally, the alarm process subroutine is constituted in steps 201, 202.

In the key depression process subroutine following the alarm process subroutine, first, in step 203, it is determined whether the key is depressed or not. If it is found out that the key depression is interrupted for, for example, over 5 minutes, then the power supply key 8 is automatically turned off in step 204 following the step 203. However, if the key depression was made prior to the execution of such an automatic shut-off, then, in step 205, a key code corresponding to the key input is stored into a key buffer area of RAM 4. However, also in this case, in order for the operating instruction corresponding to the key input to be issued, it is necessary to wait until step 207 within the main routine is reached.

Thus, upon completion of the key depression process subroutine, CPU 19 executes a process for blinking the cursor in step 206 following the step 205, and finally determines whether the interrupt cycle has elapsed or not to return from step 207 to step 201.

In the process of responding to various key depression within the main routine, CPU 19 can always know from the state of the switch 27 under its own control whether the motor 20 of the floppy disk unit 17 is electrically conductive or not.

Figure 5 illustrates the timer interrupt routine executed by the timer interruption. If the timer interrupt routine is executed, then, first, in the initial step 200, it is determined whether the motor 20 is turned on or not. If the switch 27 is open and the motor 20 is in the non-driven condition, then, in step 202, the switch 22 is switched to the power supply 30 side, and the high voltage threshold V_{H} is set to the voltage monitor 21. If, on the contrary, the switch 27 is closed and the motor is being driven, then, in step 203, the switch 22 is switched to the power supply 24 side, and the low voltage threshold V_{L} is set to the voltage monitor 21.

As described above, the threshold voltage is switched to either one of the low and high voltages V_{L}, V_{H} depending on whether the electricity is conductive or not, but if the output voltage V₀ of the battery 15 which is applied to the comparing input terminal of the comparator 21b within the voltage monitor 21 becomes lower than the threshold voltage V_{L} or V_{H} given to the reference input terminal and the output of the comparator 21b is turned into LOW level, then an alarm flag is established in step 205 receiving the result of determination in step 204.

As described above, in the battery-driven electronic appliance, either one of the two high and low threshold voltages V_{H}, V_{L} is selectively set to the voltage monitor 21 (monitors the advent of the replacing or recharging time according to whether the output voltage V₀ of the battery 15 is large or small) depending on whether any specific load of the group of loads of the battery 15, that is, the motor 20 of the floppy disk unit 17 is being driven or not. In consequence, such a situation can be avoided in which, regardless of the fact the output voltage V₀ of the battery is lowered due to the load current resulting from the driven motor 20, as a result of monitoring the battery voltage under the nearly similar condition as when a light load is in use, the advent of the replacing or recharging time is informed by mistake at the early stage in which the discharging of the battery 15 is small with the result that a situation can be avoided in which the next time working power is limited by the charging entailing the memory effect. That is, since, during the operation of the motor 20, the accidental discharging can securely be prevented by lowering the threshold voltage from V_{H} to V_{L}, development of the memory effect can be nipped in the bud while the potential capability of the battery 15 can be sufficiently realized and the battery life-time can be secured over a long period of time.

Furthermore, since the threshold voltage generator comprises the two kinds of high and low threshold voltage sources 23, which are selectively connected to the terminal for applying the threshold voltage of the voltage monitor 21 by way of the switch 22 and a CPU 19, which is the control means for issuing the operating instruction to the motor 20 while making the interface circuit 18 switch to the switch 22 in interlocking relationship with the operating instruction, in order to establish the monitoring system, only the threshold voltage sources 23, 24 may be connected by way of the switch 22 to make the voltage of each threshold voltage sources 23, 24 correspond to the high and low voltage threshold values V_{H}, V_{L} respectively. As a result, in order to monitor the battery voltage, since the switch 22 may only be switched according to the operating state of the motor 20, the mistake in setting the threshold voltage value is small, and the exact monitoring of the battery voltage can always be achieved.

Furthermore, since the specific load is arranged with the floppy disk unit 17 which drives the floppy disk 3 for rotation by the motor made electrically conductive for driving by the battery 15 to read and write data to and from the floppy disk 3, the output voltage V₀ of the battery 15 is lowered by the voltage obtained by multiplying the current consumption by the resistance within the battery due to the current consumed by the motor 20 as the floppy disk 3 is rotated. However, since the voltage drop involved with such a load current can be previously confirmed by calculation or experiment, it is possible to set the voltages V_{H}, V_{L} set to the voltage monitor 21 properly to manage a proper recharging time considering the operating state of the load.

Although, in the foregoing description, switching of the switch 22 is conducted in correspondence with the open/close timing of the switch 27, upon driving of the floppy disk unit 17, the low voltage threshold V_{L} is almost immediately set while when it stops operating it is also possible to switch to the high voltage value V_{H} after at least a period of time (the below-described settling time T) exceeding the transient response delay time t has elapsed after the operation is stopped. Thus, it is possible to prevent the mistaken determination resulting from the transient response delay time t. In step 201, it is determined whether the settling time T corresponding to about 1.5 times of the transient response delay time t of the battery output voltage V₀ or not. For example, if the transient response delay time t of the battery 15 is on the order of 3 sec, then the settling time is set to about 5 sec.

The settling time is a time enough to restore the battery output voltage V₀ after the load is reduced; before the settling time T does not elapse, setting of the low voltage threshold value V_{L} is continued in step 202. However, if, in step 202, the settling time T elapses after it is found out that the motor 20 stops, then, since the output of the motor 20 is unquestionably stable well enough, in step 203 following the result of determination in the affirmative 201 in step 201, the switch 22 is switched to the power supply 23 side, and the high voltage threshold value V_{H} is set to the battery voltage monitor 21. In consequence, since the high voltage threshold value V_{H} is set before the output voltage V₀ of the battery 15 has completely recovered, any trouble in which, even temporarily, the battery voltage monitor 21 tells the advent of the battery replacing time by accident cannot happen.

Incidentally, since, in the condition in which the motor 20 keeps the non-driven condition, there is a possibility that shifting to step 203 is delayed by the functioning step 2O1, this delay is on the order of the settling time T, i.e., at most, 5.6 sec, and causes a great problem in informing the battery replacing or recharging time.

On the other hand, if the switch 27 is closed and the motor 20 is operating, in step 202, the switch 22 is immediately switched to the power supply 24 side, and the low voltage threshold value V_{L} is set to the battery voltage monitor 21. In this case, even if the output voltage V₀ of the battery 15 drops with a slight delay because it was immediately after the motor 20 started to operate, since a slight delay in monitoring which corresponds to this time delay happens, the intentional monitoring timing offset as when the threshold voltage value is switched from the low voltage V_{L} to the high is not necessary.

In the foregoing embodiment, the output voltage V₀ of the battery 15 is constantly monitored by the battery voltage monitor 21, CPU 19, when the motor 20 of the floppy disk unit 17 is being driven, suffers a remarkable reduction (about 0.5 V) of the output voltage V₀ of the battery 15 which is involved with the increase of the current consumption.

Incidentally, although, in the foregoing embodiment, the floppy disk unit 17 was taken for example, the specific load of the battery 15, CD-ROM unit or other various units may be used as such.

## Claims

1. A battery-driven electronic appliance comprising:
a CPU (19) for carrying out the processing corresponding to key depression while, unless any key is depressed for over a predetermined period of time, shifting to HALT state to select the power saving mode, during which it waits for key depression;
a battery voltage monitor (21) for monitoring the output voltage of a battery (15) to generate a battery alarm signal according to the result of determination in the light of a threshold value;
an interface circuit (18) for converting the battery alarm signal emitted by said battery voltage monitor to an alarm code which is the pseudo key code to feed into said CPU as the key input;
a group of loads (17, 31) operating upon receipt of the supply of current from said battery (15);
means (26) for generating two different threshold voltage values; and
voltage switching means (22) for, while one or more specific loads selected from among said group of loads are operating, selecting the lower output voltage of said threshold voltage value generating means and for, while said load or loads are not operating, selecting the higher output voltage of said threshold voltage value generating means, wherein
said battery voltage monitor (21) is connected to an electrically conductive line (28) connecting said group of loads and said battery for determining whether the output voltage of said battery is greater or smaller than either one of said two threshold voltage values taken as the reference to generate said alarm signal.

2. The battery-driven electronic appliance according to claim 1 wherein said alarm code comprises a key code released for setting by user which is contained within the code system defining the key input and the corresponding key code.

3. The electronic appliance according to claim 1 or 2 wherein said threshold voltage value generating means (26) comprises two voltage sources for generating different threshold voltage values and a switch for, while said specific load(s) is (are) operating, selecting the voltage source the output voltage of which is lower and for, while it (they) is (are) not operating, selecting the voltage source the output voltage of which is higher.

4. The electronic appliance according to claim 3 comprising means for, when said specific load(s) operate(s), switching the output voltage of said threshold voltage value generating means immediately and for, when said specific load(s) stop(s), switching it to the higher voltage after a transient response delay has elapsed after it (they) stop(s) operating.

5. The electronic appliance according to any of claims 1 to 4 wherein said battery comprises a primary battery.

6. The electronic appliance according to any of claims 1 to 4 wherein said battery comprises a secondary battery.

7. The electronic appliance according to any of claims 1 to 6 wherein said specific load(s) comprise(s) a floppy disk unit.

## Patentansprüche

1. Batteriebetriebenes elektronisches Gerät mit:
einer CPU (19) zum Ausführen der Verarbeitung, die einem Tastendruck entspricht, während sie, wenn länger als eine bestimmte Zeitdauer keine Taste gedrückt wird, in einen HALTE-Zustand schaltet, um den Leistungssparmodus auszuwählen, während dem sie auf einen Tastendruck wartet;
einer Batteriespannungsüberwachung (21) zum Überwachen der Ausgangsspannung einer Batterie (15), um ein Batteriealarmsignal gemäß des Ergebnisses der Bestimmung bezüglich eines Schwellenwerts zu erzeugen;
einer Schnittstellenschaltung (18) zum Umwandeln des von der Batteriespannungsüberwachung ausgegebenen Batteriealarmsignals in einen Alarmcode, der der Pseudotastencode ist, um ihn der CPU als die Tasteneingabe zuzuführen;
einer Gruppe von Verbrauchern (17, 31), die nach Empfang der Stromzufuhr aus der Batterie (15) arbeiten;
einer Einrichtung (26) zum Erzeugen zweier verschiedener Schwellenspannungswerte; und
einer Spannungsumschalteinrichtung (22) zum Auswählen der niedrigeren Ausgangsspannung der Schwellenspannungswerterzeugungseinrichtung, während ein oder mehrere spezielle Verbraucher der Gruppe von Verbrauchern arbeiten, und zum Auswählen der höheren Ausgangsspannung der Schwellenspannungswerterzeugungseinrichtung, während der Verbraucher oder die Verbraucher nicht arbeiten, wobei die Batteriespannungsüberwachung (21) mit einer elektrisch leitenden Leitung (28) verbunden ist, die die Gruppe von Verbrauchern und die Batterie verbindet, um zu bestimmen, ob die Ausgangsspannung der Batterie größer oder kleiner ist als irgendeine der beiden Schwellenspannungswerte, die als Vergleich genommen werden, um das Alarmsignal zu erzeugen.

2. Batteriebetriebenes elektronisches Gerät nach Anspruch 1, wobei der Alarmcode einen Tastencode aufweist, der zur Einstellung durch einen Benutzer freigegeben wird, und der innerhalb des Codesystems enthalten ist, das die Tasteneingabe und den entsprechenden Tastencode bestimmt.

3. Elektronisches Gerät nach Anspruch 1 oder 2, wobei die Schwellenspannungswerterzeugungseinrichtung (26) zwei Spannungsquellen zum Erzeugen verschiedener Schwellenspannungswerte und einen Schalter aufweist, um, während der (die) spezielle(n) Verbraucher arbeitet (arbeiten), die Spannungsquelle auszuwählen, deren Ausgangsspannung niedriger ist, und um, während er (sie) nicht arbeitet (arbeiten), die Spannungsquelle auszuwählen, deren Ausgangsspannung höher ist.

4. Elektronisches Gerät nach Anspruch 3, das eine Einrichtung aufweist, um, wenn der (die) spezielle(n) Verbraucher arbeitet (arbeiten), die Ausgangsspannung der Schwellenspannungswerterzeugungseinrichtung sofort umzuschalten, und um, wenn der (die) spezielle(n) Verbraucher anhält (anhalten), sie auf die höhere Spannung umzuschalten, nachdem eine Einschwingverzögerungszeit verstrichen ist, nachdem er (sie) das Arbeiten beendet (beenden).

5. Elektronisches Gerät nach einem der Ansprüche 1 bis 4, wobei die Batterie eine Primärbatterie ist.

6. Elektronisches Gerät nach einem der Ansprüche 1 bis 4, wobei die Batterie eine Sekundärbatterie ist.

7. Elektronisches Gerät nach einem der Ansprüche 1 bis 6, wobei der (die) spezielle(n) Verbraucher eine Disketteneinheit aufweist (aufweisen).

## Revendications

1. Appareil électronique alimenté par une batterie comprenant :
une CPU (19) pour exécuter le traitement correspondant à un enfoncement de touche tout en passant à un état ARRET, à moins qu'une touche soit enfoncée sur une période de temps prédéterminée, pour sélectionner le mode d'économie d'énergie, pendant lequel elle attend un enfoncement de touche ;
un dispositif de contrôle de tension de batterie (21) pour contrôler la tension de sortie d'une batterie (15) afin d'engendrer un signal d'alarme de batterie selon le résultat de la détermination à la lumière d'une valeur de seuil ;
un circuit d'interface (18) pour convertir le signal d'alarme de batterie émis par ledit dispositif de contrôle de tension de batterie en un code d'alarme qui est le pseudo-code de touche à entrer dans ladite CPU comme signal d'entrée de touche ;
un groupe de charges (17, 31) fonctionnant à la réception du courant d'alimentation provenant de ladite batterie (15) ;
des moyens (26) pour engendrer deux valeurs de tension de seuil différentes ; et,
des moyens de commutation de tension (22) pour sélectionner la tension de sortie inférieure desdits moyens de génération de valeur de tension de seuil, pendant qu'une ou plusieurs charges particulières sélectionnées dans ledit groupe de charges sont en fonctionnement, et pour sélectionner la tension de sortie supérieure desdits moyens de génération de valeur de tension de seuil, pendant que ladite charge ou lesdites charges ne sont pas en fonctionnement,
dans lequel ledit dispositif de contrôle de tension de batterie (21) est connecté à une ligne électriquement conductrice (28) connectant ledit groupe de charges et ladite batterie pour déterminer si la tension de sortie de ladite batterie est plus grande ou plus petite que l'une desdites deux valeurs de tension de seuil prises comme référence pour engendrer ledit signal d'alarme.

2. Appareil électronique alimenté par une batterie selon la revendication 1, dans lequel ledit code d'alarme comprend un code de touche lancé pour un établissement par un utilisateur qui est contenu dans le système de code définissant le signal d'entrée de touche et le code de touche correspondant.

3. Appareil électronique selon la revendication 1 ou 2, dans lequel lesdits moyens de génération de valeur de tension de seuil (26) comprennent deux sources de tension pour engendrer des valeurs de tension de seuil différentes et un commutateur pour sélectionner la source de tension dont la valeur de sortie est inférieure, pendant que ladite(lesdites) charge (s) particulière(s) est (sont) en fonctionnement, et pour sélectionner la source de tension dont la tension de sortie est supérieure, pendant qu'elle(s) n'est(ne sont) pas en fonctionnement.

4. Appareil électronique selon la revendication 3, comprenant des moyens pour commuter la tension de sortie desdits moyens de génération de valeur de tension de seuil immédiatement, quand ladite(lesdites) charge(s) particulière(s) fonctionne(nt), et pour la commuter vers la tension supérieure après qu'un temps de réponse transitoire s'est écoulé après son(leur) arrêt de fonctionnement, quand ladite(lesdites) charge(s) s'arrête(nt).

5. Appareil électronique selon l'une quelconque des revendications 1 à 4, dans lequel ladite batterie comprend une batterie principale.

6. Appareil électronique selon l'une quelconque des revendications 1 à 4, dans lequel ladite batterie comprend une batterie secondaire.

7. Appareil électronique selon l'une quelconque des revendications 1 à 6, dans lequel ladite(lesdites) charge (s) particulière(s) comprend (comprennent) une unité de disquette.
